Europäisches Patentamt

(19) European Patent Office

Office européen des brevets

(11) Publication number : **0 416 787 B1**

(12) **EUROPEAN PATENT SPECIFICATION**

(45) Date of publication of patent specification :
**10.05.95 Bulletin 95/19**

(51) Int. Cl.[6] : **H01L 21/306,** H01J 37/32,
C23C 14/54, H01L 21/66

(21) Application number : **90309299.7**

(22) Date of filing : **24.08.90**

(54) **Plasma processing of III-V semiconductors, controlled by photoluminescence spectroscopy.**

(30) Priority : **01.09.89 US 402030**

(43) Date of publication of application :
**13.03.91 Bulletin 91/11**

(45) Publication of the grant of the patent :
**10.05.95 Bulletin 95/19**

(84) Designated Contracting States :
**DE FR GB**

(56) References cited :
**EP-A- 0 070 523
DE-A- 3 002 509
US-A- 4 377 436
US-A- 4 528 438
US-A- 4 713 140
JOURNAL OF APPLIED PHYSICS, vol. 68, no.
2, 15 July 1990, pp. 440-445 ; R.A. GOTTSCHO
et al. : "Real-time monitoring of low-temperat-
ure hydrogen plasma passivation of GaAs"**

(56) References cited :
**APPLIED PHYSICS LETTERS, vol. 56, no. 9, 26
February 1990, pp. 821-823 ; A. MITCHELL et
al. : "Real-time, in situ monitoring of GaAs and
A1GaAs photoluminescence during plasma
processing"
RESEARCH DISCLOSURE, no. 27731, page
308, May 1987, Havant, GB ; "Chromium Plas-
ma Etch Process with Endpoint Detection"
PATENT ABSTRACTS OF JAPAN, vol. 12, no.
407 (E-675), 27 October 1988 ; & JP-A-63 148
694
MATERIALS SCIENCES FORUM, vol. 10-12,
1986, pp. 579-583 ; J. WEBER et al. :
"Photoluminescence Detection of the Shallow
Impurity Neutralization in GaAs"**

(73) Proprietor : **AT & T Corp.
32 Avenue of the Americas
New York, NY 10013-2412 (US)**

(72) Inventor : **Gottscho, Richard Alan
118 Midland Boulevard
Maplewood, New Jersey 07040 (US)**

(74) Representative : **Johnston, Kenneth Graham et
al
AT&T (UK) LTD.
AT&T Intellectual Property Division
5 Mornington Road
Woodford Green Essex, IG8 OTU (GB)**

## Description

This invention relates to methods for passivating the surface of a III-V semiconductor.

Real-time, in situ diagnostic techniques such as optical emission spectroscopy and laser interferometry have proven valuable for both plasma process control and development. In particular, these methods have been widely used for rate and endpoint detection. The needs for in situ monitoring will increase further as device processing evolves from the cleanroom to integrated, in situ processing in a mulit-stage chamber. Besides endpoint and rate monitoring, it will be necessary to monitor properties of the wafer that correlate directly with device performance so that process parameters can be optimized and controlled.

Application of photoluminescence spectroscopy for monitoring material properties during plasma processing, i.e., for endpoint detection, is particularly advantageous because: (1) large quantum yields permit sensitive detection in the presence of an intense plasma glow; (2) quantum yields are dependent on surface state density and are correlated with device performance; (3) the photoluminescence spectrum is material specific so that wavelength differentiation can be used for endpoint detection; and, (4) the photoluminescence spectral peak position can be used to monitor wafer temperature.

Plasma etching III-V compounds is important for a number of device applications. In general, etching should be anisotropic, selective, uniform, and damageless. Although it is often difficult to achieve these attributes simultaneously and trade-offs between them are usually necessary, both plasma chemistry and plasma diagnostic techniques can be manipulated to achieve the desired result. For example, in fabricating infrared detectors, an endpoint detector or an etch stop-layer (or both) is required to remove, e.g. AlGaAs, without removing any GaAs substrate material. An etch-stop layer of InGaAs could be used but epitaxial growth complexity is increased. Photoluminescence endpoint detection that distinguishes between AlGaAs and GaAs could obviate the need for the etch-stop layer.

For self-aligned, heterostructure field effect transistors (HFETs), GaAs is removed from AlGaAs and a careful choice of plasma gas composition provides a natural etch-stop. However, in this case, it is important to minimize plasma-induced damage that alters device threshold voltages. Plasma-induced surface disordering can also deleteriously affect subsequent processing steps such as epitaxial regrowth or metallization. Thus, photoluminescence monitoring of damage could help in developing methods to either minimize it or remove it.

The use of photoluminescence for plasma etch endpoint detection in III-V heterostructures is described in detail in U.S. Patent No. 4,713,140. This patent teaches a technique for sensing the endpoint at which a layer of one III-V composition is completely etched through to a substrate layer of another III-V composition. This is achieved in one embodiment according to the patent by sensing the point at which photoluminescence from the substrate reaches a predetermined threshold. That threshold is set empirically.

US-A-4377436 discloses that endpoint detection during plasma-assisted etching may be signalled by cessation or onset of spatially confined luminescence resulting from an etch reaction product. Sensitivity of the system is aided by an optically focused detector which selectively detects such fluorescence as associated with one or a small number of lithographic features.

MATERIALS SCIENCE FORUM vol. 10-12, 1986, pages 579-583; J. WEBER et al.: "Photoluminescence Detection of the Shallow Impurity Neutralization in GaAs", pages 579,580 discloses that neutralization of the shallow impurities in GaAs by atomic hydrogen may be monitored by low-temperature photoluminescence spectroscopy. The reduced donor concentration after hydrogen plasma treatment gives rise to a diminished intensity of the donor-related optical transitions. While the overall photoluminescence intensity of the acceptor-related transitions increases, the relative intensities of luminescence lines correlated with different acceptor species change. This behavior indicates a weak neutralization of even the shallow acceptors in GaAs.

According to this invention there is provided a method as claimed in claim 1.

We have discovered that induced photoluminescence from III-V semiconductors can be used for improved control of time dependent plasma processes. The photoluminescence from surfaces being treated is found to diminish sharply under certain circumstances, and the sharp drop can be used as a precise indicator of the endpoint of the process. It has also been found that in surface passivation processes, e.g. hydrogen plasma passivation, the maximum in photoluminescence indicates the onset of surface damage. Continued exposure of the surface to the hydrogen plasma, previously assumed to be harmless, actually degrades the surface to the point where surface damage reaches or exceeds the preprocess condition. The endpoint of this process is the onset of the decline in photoluminescence, i.e. at the maximum in the photoluminescent signal.

In the processes described herein, the endpoint is determined by the photoluminescence signal itself and is not dependent on predetermined thresholds set empirically or otherwise. It is through a thorough understanding of the photoluminescence process in the III-V semiconductor materials, and the discovery of unexpected photoluminescent phenomena in these materials, that allows the photoluminescent signal to precisely define process parameters.

## Detailed Description

To demonstrate the inventive techniques, two types of samples were used: semi-insulating (SI) GaAs substrate and SI GaAs substrates with epitaxial layers of $Al_{0.3}Ga_{0.7}As$ (1 μm) and GaAs (10nm) grown by Metal-Organic Chemical Vapor Deposition.

The experimental arrangement is similar to that reported recently for photoemission optogalvanic diagnostic measurements. (See reference: S. W. Downey, A. Mitchell, and R. A. Gottscho, J. Appl. Phys. 63, 5280 [1988]). Photoluminescence is generated by using a p-polarized, pulsed $N_2$ pumped dye laser beam incident at ~ 80° from normal. The laser pulse energy is typically 260 μJ of 504 nm light and is slightly focussed onto the sample to a spot size of about 0.15 cm². Photoluminescence is collected, collimated, and then focussed onto the entrance slit of either a scanning monochromator equipped with a photomultiplier tube (PMT) or a spectrograph equipped with a gated, intensified diode array. The output of the PMT is monitored using a gated integrator; the diode array is interfaced to a signal averager. Both the gated integrator and signal averager are interfaced to a microcomputer.

A pulsed laser arrangement is preferable to continuous-wave excitation since the photoluminescence signal is linear with laser pulse energy from 10 to 300 μJ. Thus, a short, high intensity pulse and gated detection eliminates the plasma background glow. In addition, a low duty-cycle pulsed laser deposits less energy into the sample and thereby minimizes heating and photodegradation.

Samples are processed in a parallel-plate, capacitively-coupled reactor. Briefly, we use a six-way pyrex cross with 7.6 cm diameter anodized A1, water-cooled electrodes and a gap of 3 cm. The wafer is grounded and the top electrode is connected to a 13 MHz power supply through a and pi matching network. Power measurements are made by multiplying digitized current and voltage waveforms. For etching, we use 5 sccm of $BCl_3$ at 21 Pa (160 m Torr) and 20-25 W. For damage passivation, we use 5 sccm of $H_2$ at 67 Pa (500 mTorr) and 4-6 W.

Simple expressions relating $Al_{0.3}Ga_{0.7}As$ and GaAs photoluminescence intensities to $Al_{0.3}Ga_{0.7}As$ layer thickness during etching are derived by assuming: (1) flatband conditions; (2) constant quantum yield; (3) constant reflectivity at the $Al_{0.3}Ga_{0.7}As$-plasma interface and negligible reflectivity at the $Al_{0.3}Ga_{0.7}As$-GaAs interface; and, (4) negligible photoluminescence absorption in either the GaAs substrate or the $Al_{0.3}Ga_{0.7}As$ epitaxial layer. For $Al_{0.3}Ga_{0.7}As$ photoluminescence at 667 nm,

$$I_e(\chi) = I_e^0[1 - e^{(-\alpha_e d_e(1-\chi))}]/[1 - e^{-\alpha_e d_e}] \quad \text{for } \chi < 1$$

and

$$I_e(\chi) = 0 \quad \text{for } \chi \geq 1$$

where $I_e(\chi)$ is the photoluminescence intensity as a function of normalized etched depth $\chi = x/d_e$, $I_e^0$ is the initial photoluminescence intensity, $\alpha_e$ is the absorption coefficient, $d_e$ is the initial $Al_{0.3}Ga_{0.7}As$ layer thickness, and the subscript e refers to the epitaxial $Al_{0.3}Ga_{0.7}As$ layer. For the GaAs substrate photoluminescence at 868 nm:

$$I_s(\chi) = I_s^\infty e^{-\alpha_e d_e(1-\chi)} \quad \text{for } \chi < 1$$

and

$$I_s(\chi) = I_s^\infty \quad \text{for } \chi \geq 1,$$

where the s subscript refers to the SI GaAs substrate and $I_s^\infty$ refers to the final GaAs photoluminescence intensity in the absence of damage (flat-band conditions).

## Description of the Drawings

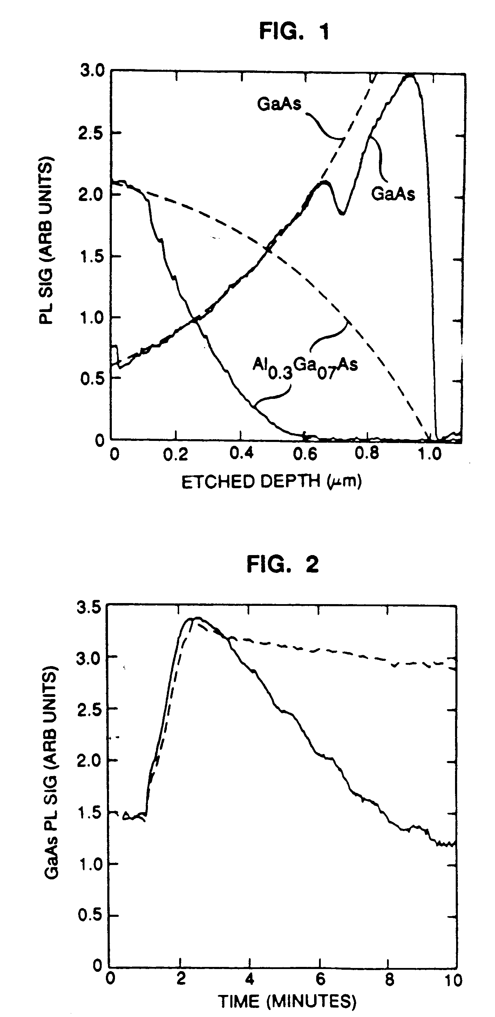

FIGS. 1-3 are plots showing induced photoluminescent maxima used for control of time dependent plasma processing.

FIG. 1 gives data for the etching process just described. The dashed lines are calculated photoluminescence intensities using Eqns. 1 and 2 and $I_e^0 = 2.1$, $I_s^\infty = 4.43$, and $\alpha_e d_e = 2$. Typical etch times for 1 μm $Al_{0.3}Ga_{0.7}As$ films range from 10 to 25 min. depending on sample size. The observed variations in photoluminescence intensity are shown as solid lines in Fig. 1. Contrary to expectations based on the simple assumptions above, photoluminescence from $Al_{0.3}Ga_{0.7}As$ decreased more rapidly and disappears before endpoint. Part of this decrease may be due to carrier injection and trapping in the underlying GaAs. Photoluminescence from GaAs initially increases exponentially, but deviates from the predicted curve at the point where the $Al_{0.3}Ga_{0.7}As$ photoluminescence becomes negligible and decreases dramatically when the $Al_{0.3}Ga_{0.7}As$ layer is removed.

The differences between observation and prediction are consistent with deviations from the flat-band condition caused by plasma-induced damage. Surface-states created by plasma exposure decrease photoluminescence intensity in two ways. Firstly, charged surface states can induce band bending and a strong electric field in the bulk; this field separates electron-hole pairs and reduces the radiative recombination rate. Secondly, defects can enhance nonradiative recombination. From the data, the thickness of the dark-space layer appears to encompass the $Al_{0.3}Ga_{0.7}As$ layer and penetrate into the underlying GaAs when ≈ 0.3 μm of $Al_{0.3}Ga_{0.7}As$ remains. At endpoint, the GaAs surface is exposed directly to the damaging, etching plasma and the photoluminescence intensity drops sharply.

Uncapped GaAs surfaces exhibit lower photoluminescence yield than those capped with AlGaAs because of Ga and As oxide formation and elemental As accumulation that produce a high surface-state density in the former. Multipolar $H_2$ plasmas have been used to remove this layer at 200°C and after nitridation, increased photolumnescence yield and improved MESFET performance were obtained.

Using rf $H_2$ and $N_2$ plasma treatments, it has been shown that the Fermi level at the surface of n-type GaAs could be unpinned. Treatment of InP surfaces with $H^+$ ions results in a similar increase of photoluminescence intensity when monitored ex situ. For both InP and GaAs, the activated hydrogen treatment presumably reduces native oxides and compensates dangling bond defects that facilitate electron-hole recombination.

FIG. 2 shows the real-time increase in GaAs photoluminescence intensity when SI GaAs is first exposed to a $H_2$ plasma at 25°C. As the $H_2$ plasma treatment continues the surface is damaged and the photoluminescence yield decreases rapidly (solid line in Fig. 2). If the plasma is turned off at the peak (dashed curve in Fig. 2), the photoluminescence intensity decreases much more slowly. Upon subsequent plasma exposure, the photoluminescence increases again and remains stable for 24 hours through the base pressure in this system is only 0.07 Pa (0.5 mTorr). Even when passivated samples are exposed to air for at least 8 days, the photoluminescence intensity remains steady at the enhanced level to better than 10%. These results show the value of real-time monitoring in optimizing the length of time the wafer is procesed.

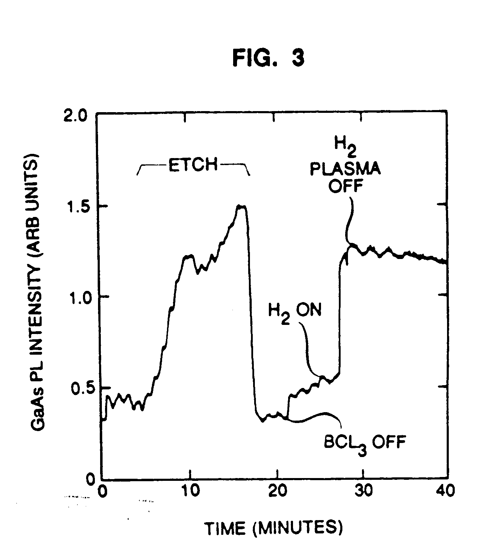

FIG.3, an etch-passivation sequence is demonstrated. After removing 1 $\mu$m of $Al_{0.3}Ga_{0.7}As$, the damaged GaAs substrate is passivated using a brief, room temperature $H_2$ plasma exposure.

As indicated above, an aspect of the invention is based on the technological use, during wafer manufacture, of sharp transients in the photoluminescence induced from a III-V semiconductor surface. In the case of the maxima, it may be necessary to account for small turnover points that are artifacts not true endpoints. For example, referring to Fig. 1 there appears a distinct inflection in the photoluminescence curve before the actual endpoint. It is expected that this smaller maxima can be related reliably to the actual endpoint and may itself be useful as a process control point. However, in a preferred case the process is continued until a drop in the photoluminescence of at least 50% is measured. This will insure against premature termination due to small variations during etching.

In the passivation process, the photoluminescent response is somewhat different. The photoluminescence undergoes a sharp transition just before the maxima. Therefore the indicator of the maxima may not be an inflection point but the endpoint indicator may be the steep rise in photoluminescence. In either case the presence of the maxima indicates the stage in the process that determines the control point, whether the rise, the peak, or the drop is used as the trigger.

## Claims

1. A method of passivating the surface of a III-V semiconductor comprising exposing the surface to a hydrogen plasma for a period sufficient to passivate the surface, characterized in that said period is determined by a measured maximum in induced photoluminescence from said surface while the surface is exposed to the hydrogen plasma.

2. A method as claimed in claim 1 in which the hydrogen plasma is sustained by electrical power, and the electrical power is terminated in response to the measured maximum in induced photoluminescence.

3. A method as claimed in claim 2 in which the photoluminescence is induced by directing a beam of radiation onto said surface.

4. A method as claimed in claim 3 in which the beam of radiation is a laser beam.

## Patentansprüche

1. Verfahren zur Passivierung der Oberfläche eines III-V-Halbleiters umfassend
das Aussetzen der Oberfläche einem Wasserstoffplasma für eine Zeitdauer, die ausreichend ist, um die Oberfläche zu passivieren,
dadurch gekennzeichnet, daß die Zeitdauer durch ein gemessenes Maximum der induzierten Photolumineszenz von der Oberfläche festgestellt wird, während die Oberfläche dem Wasserstoffplasma ausgesetzt ist.

2. Verfahren nach Anspruch 1,
bei welchem das Wasserstoffplasma durch elektrische Leistung erhalten wird und die Zuführung elektrischer Leistung in Antwort auf das gemessene Maximum der induzierten Photolumineszenz beendet wird.

3. Verfahren nach Anspruch 2,
bei welchem die Photolumineszenz durch Richten eines Strahls von Strahlung auf die Oberfläche induziert wird.

4. Verfahren nach Anspruch 3,
bei welchem der Strahl von Strahlung ein Laserstrahl ist.

**Revendications**

1. Un procédé de passivation de la surface d'un semiconducteur III-V, comprenant l'exposition de la surface à un plasma d'hydrogène pendant une durée suffisante pour passiver la surface, caractérisé en ce que cette durée est déterminée par un maximum mesuré dans la photoluminescence induite à partir de cette surface, pendant que la surface est exposée au plasma d'hydrogène.

2. Un procédé selon la revendication 1, dans lequel le plasma d'hydrogène est entretenu par de l'énergie électrique, et l'énergie électrique est interrompue sous l'effet du maximum mesuré dans la photoluminescence induite.

3. Un procédé selon la revendication 2, dans lequel la photoluminescence est induite en dirigeant un faisceau de rayonnement sur la surface.

4. Un procédé selon la revendication 3, dans lequel le faisceau de rayonnement est un faisceau laser.

## FIG. 1

## FIG. 2

FIG. 3